# EUROPEAN PATENT SPECIFICATION

(11) **EP 3 051 558 B1**
(45) Date of publication and mention of the grant of the patent: **03.04.2019**
(21) Application number: 16150939.3
(22) Date of filing: 12.01.2016
(51) Int. Cl.: H01H 50/02, H01H 51/28, H01H 50/04, H01H 33/662

(54) **HIGH-TEMPERATURE, HIGH-PRESSURE VACUUM RELAY**
HOCHTEMPERATUR-, HOCHDRUCKVAKUUMRELAIS
RELAIS SOUS VIDE À HAUTE PRESSION, À HAUTE TEMPÉRATURE

(30) Priority: 21.01.2015 US 201562105862 P
(43) Date of publication of application: 03.08.2016
(73) Proprietor: Thomas & Betts International LLC, Wilmington, DE 19809 (US)
(72) Inventor: BIRNIE, Jason, Sunnyvale, CA 94087 (US); FRIAS, Jose, San Jose, CA 95120 (US); GEISS, Susanne, Felton, CA 95018 (US)
(74) Representative: Carpmaels & Ransford LLP

(56) References cited:
- CN-A- 103 779 133
- US-A- 3 534 192
- US-A- 3 988 825
- US-A- 4 027 277
- US-A1- 2009 284 335

## Description

### BACKGROUND OF THE INVENTION

The present invention relates to vacuum relays for high-voltage applications. Electromagnetic relays may be used for switching high electrical currents or high voltages. These relays typically have fixed and movable contacts with an actuating mechanism supported within a sealed chamber. Air is removed from the chamber using vacuum equipment, and the chamber is then sealed so that the fixed and movable contacts can contact/separate in a vacuum environment. Such high voltage relays have been used in a variety of environments. However, these vacuum relays cannot withstand extreme high-temperature, high-pressure environments.

US Patent 4027277 A discloses a hermetically sealed relay of the reed type. CN103779133A describes an inflatable type high-voltage relay, comprising a first insulating sealing shell; a contact arranged inside the first insulating sealing shell; and the interior of the first insulating sealing shell inflated with high-pressure gas. Since the interior of the relay can be inflated with the high-pressure gas, a capability of the relay to bear pulse current when a capacitive load is switched on can be improved, and influence of contact bounce on discharge current waveform can be eliminated, and a switch-on service life can be prolonged.

### BRIEF DESCRIPTION OF THE DRAWINGS

Fig. 1 is a schematic side perspective view of a high-temperature, high-pressure vacuum relay assembly according to an implementation described herein;
Figs. 2A and 2B are a bottom view and a schematic partial cross-sectional view, respectively, of a reinforcing sheath assembly of the relay assembly of Fig. 1;
Fig. 3 is a schematic side perspective view of the relay assembly of Fig. 1 shown without an adaptor sleeve;
Fig. 4 is a schematic side view of the relay assembly of Fig. 1 shown without the adaptor sleeve;
Fig. 5 is a schematic partial cross-sectional diagram illustrating a resin envelope of the relay assembly of Fig. 1;
Fig. 6 is a schematic cross-sectional diagram illustrating a magnetic actuating component of the relay assembly of Fig. 1;
Fig.7 is schematic side view of a reinforcing sheath assembly for a relay assembly, according to another implementation;
Fig. 8 is a flow diagram of an exemplary process for converting a standard high voltage vacuum relay into a high-temperature, high-pressure vacuum relay according to an implementation described herein;
Figs. 9A and 9B are a schematic side perspective view and a schematic partial cross-sectional diagram of a high-temperature, high-pressure vacuum relay assembly according to another implementation described herein; and
Fig. 10 is a schematic partial cross-sectional diagram of a high-temperature, high-pressure vacuum relay assembly according to still another implementation described herein.

### DETAILED DESCRIPTION OF THE PREFERRED EMBODIMENTS

The following detailed description refers to the accompanying drawings. The same reference numbers in different drawings may identify the same or similar elements.

Conventional high-voltage relays cannot operate effectively in extreme high-pressure and high-temperature conditions. As used herein, extreme high-pressure conditions may include ambient pressures of up to 170,000 kPa (25,000 PSI (pounds per square inch)) or higher and extreme high-temperature conditions may include temperatures of up to 200 degrees Celsius (C) or higher. Implementations described herein provide a high-voltage vacuum relay to enable the relay to operate in such extreme conditions. The coil of the vacuum relay is a high-temperature-resistant coil that can operate at extreme high-temperature conditions. The relay is then encapsulated using a high-temperature, high-pressure epoxy adhesive that is free of voids to deflect pressure away from the relay and allow proper functionality in extreme conditions.

According to the present invention a reinforcing sheath for a high-voltage relay switch according to independent claim 1, a relay assembly according to claim 2 and a method according to claim 13 are disclosed. Further embodiments are defined in the dependent claims.

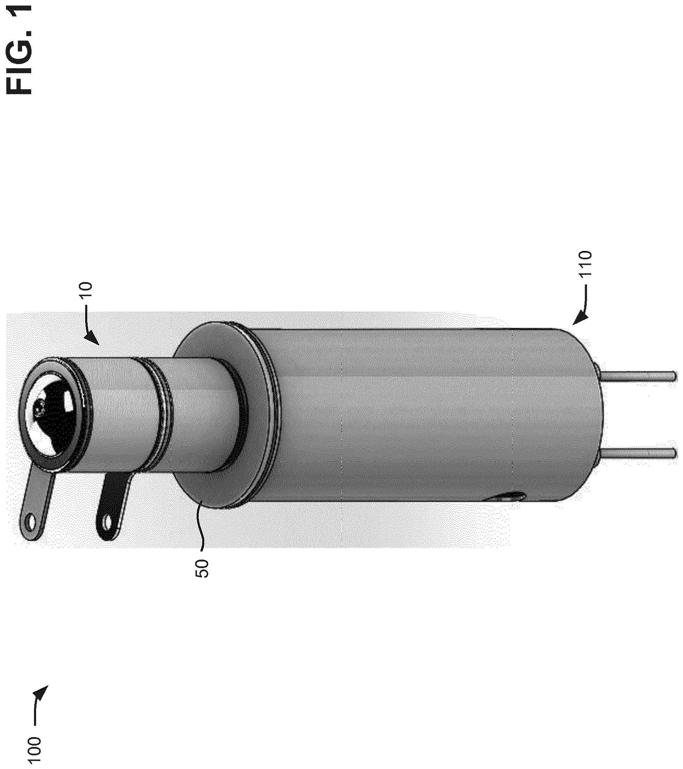

Fig. 1 provides a schematic side perspective view of a high-temperature, high-pressure vacuum relay assembly 100. As shown in Fig. 1, relay assembly 100 includes a switch body 10 that includes a flange 50. According to an implementation, switch body 10 is partially enclosed in a reinforcing sheath assembly 110.

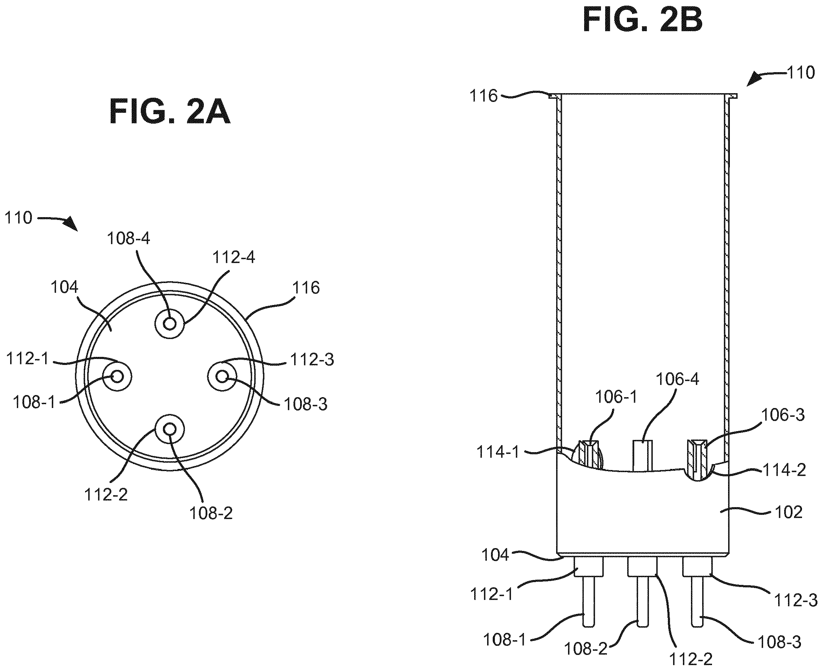

Figs. 2A and 2B provide a bottom view and a schematic partial cross-sectional diagram illustrating reinforcing sheath assembly 110. As shown in Figs. 2A and 2B, reinforcing sheath assembly 110 includes an adaptor sleeve 102, a feed-through base 104, multiple contacts 106-1 through 106-4 (referred to herein collectively as "contacts 106" and generically as "contact 106"), multiple conductors 108-1 through 108-4 (referred to herein collectively as "conductors 108" and generically as "conductor 108"), multiple insulators 112-1 through 112-4 (referred to herein collectively as "insulators 112" and generically as "insulator 112"), multiple apertures 114-1 and 114-2 in adaptor sleeve 102 (referred to herein collectively as "apertures 114" and generically as "aperture 114"), and a flange 116.

Adaptor sleeve 102 may generally form an open ended cylinder with flange 116 formed at one end and feed-through base 104 attached at the other end. Feed-through base 104 may be in the form of a disc and may be welded, brazed, or otherwise connected to adaptor sleeve 102 during production of relay assembly 100. In one implementation, adaptor sleeve 102 and feed-through base 104 may generally include strong, corrosion-resistant material with good weldability, such as a low-carbon grade stainless steel. In one example, adaptor sleeve 102 and feed-through base 104 may be made from American Iron and Steel Institute (AISI) grade 304L stainless steel.

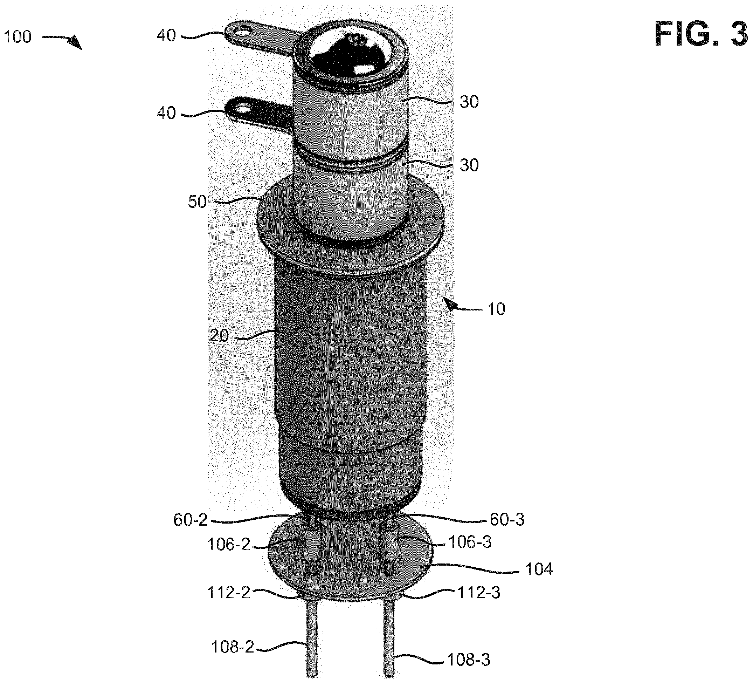

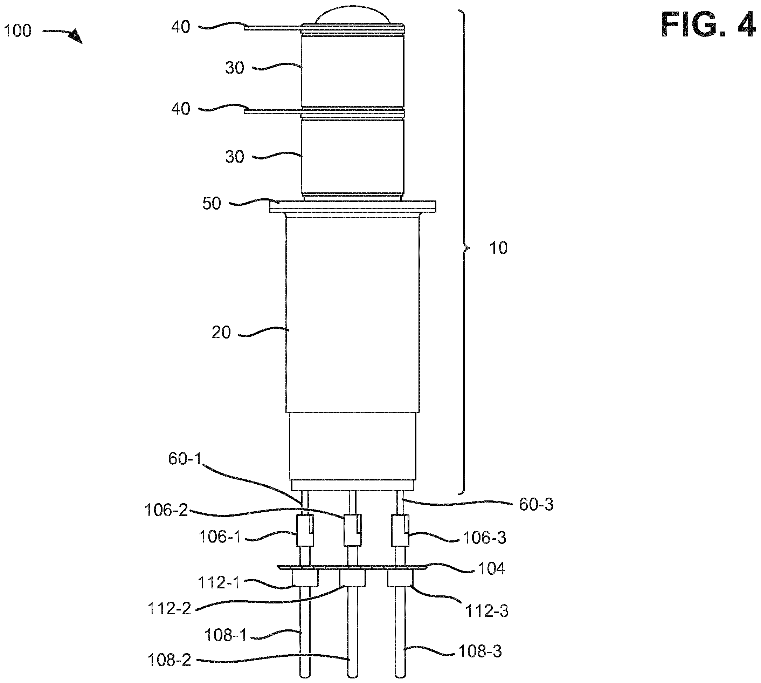

Feed-through base 104 may include a plurality of holes through which conductors 108 may pass. Each conductor 108 may include a contact 106 that is positioned inside sheath assembly 110 (e.g., inside adaptor sleeve 102). Each contact 106 may be configured to receive leads (e.g., leads 60, Figs. 3 and 4) from switch body 10. For example, each of contacts 106 may be designed to have a wiping fit on a standard-size lead (e.g., a 0.635 mm (.025 inch diameter lead)) to provide an electrical connection from the lead to a corresponding conductor 108. The wiping fit may provide an electrical contact that provides motion beyond an initial touch point. Each contact 106 may have a flexible tubular contact causes the surface of contact 106 to wipe against a corresponding lead 60 as lead 60 is inserted. Each conductor 108 may include an electrically-conductive pin that extends from one of the contacts 106 through feed-through base 104. In one implementation, contacts 106 and conductors 108 may be formed from strong, corrosion-resistant, electrically -conductive materials. In one example, contacts 106 may be formed from AISI grade 17-7 stainless steel, and conductors 108 may be formed from AISI grade 330 stainless steel.

Insulators 112 may be provided adjacent to each hole of feed-through base 104 where conductor 108 passes through. Each insulator 112 may prevent electrical contact between a respective conductor 108 and feed-through base 104. Each insulator 112 may be formed, for example, from a non-conductive glass/ceramic material, a polymer or plastic material, etc. In one implementation each insulator 112 may be brazed to feed-through base 104 adjacent to holes in feed-through base 104.

As described further herein, apertures 114 in adaptor sleeve 102 may provide an input port for epoxy resin and air outlet after sheath assembly 110 is attached to flange 50. Apertures 114 may generally be oriented between conductors 108 on opposite sides of adaptor sleeve 102 (e.g., 180 degrees apart). Flange 116 may generally extend laterally from the open end of adaptor sleeve 102 to provide a welding/brazing surface that can be attached to flange 50.

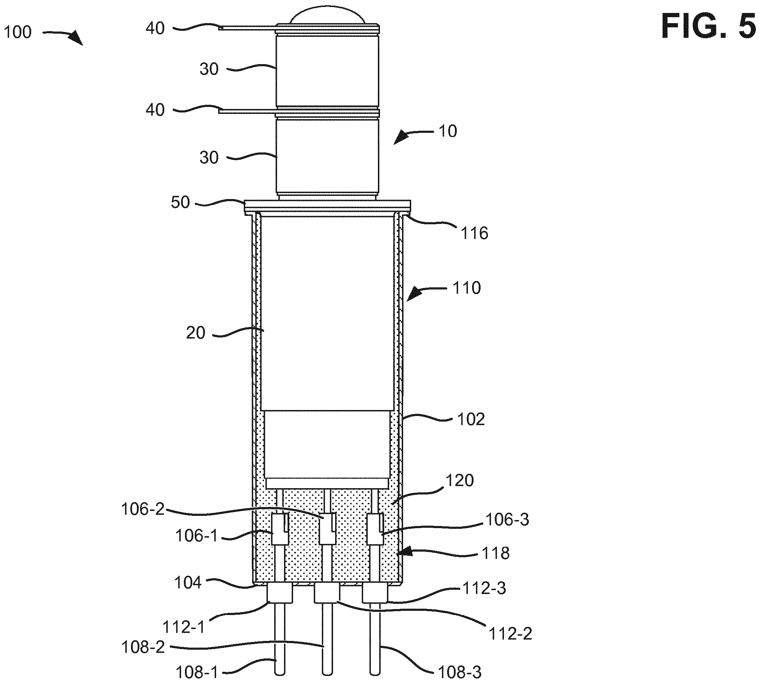

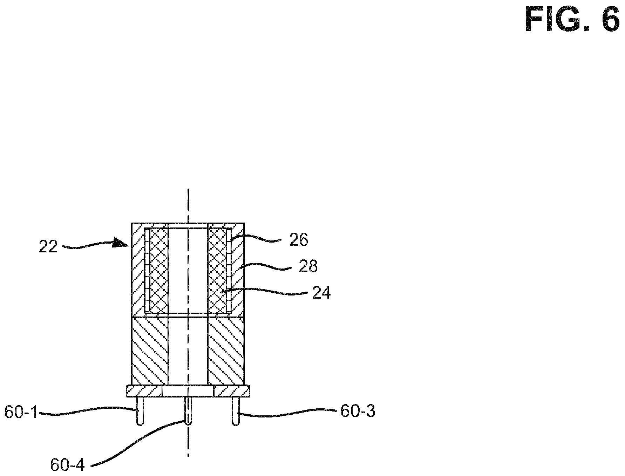

Fig. 3 provides a schematic side perspective view of relay assembly 100 shown with adaptor sleeve 102 removed for clarity, and Fig. 4 provides a side view of relay assembly 100 also shown with adaptor sleeve 102 removed for clarity. Referring collectively to Figs. 3 and 4, switch body 10 may include a coil housing 20, insulators 30, contacts 40, flange 50, and leads 60-1 through 60-4 (referred to herein collectively as "leads 60" and generically as "lead 60"). Coil housing 20 may enclose a magnetic actuating component (e.g., magnetic actuating component 22, Fig. 6). Coil housing 20 may be connected to one of insulators 30 at flange 50. Insulators 30 may enclose switching armatures and other components that selectively provide electrical connections with contacts 40 (e.g., normally open and/or normally closed contacts). Flange 50 may extend orthogonally outward beyond a diameter of coil housing 20 and/or insulators 30. Flange 50 may provide a point of attachment to join coil housing 20 with one of insulators 30. As described further below in connection with Fig. 5, flange 50 may also provide a point of attachment to mate with flange 116 of adaptor sleeve 102. Multiple leads 60 may extend from a bottom (e.g., as oriented in Figs. 3 and 4) portion of coil housing 20. Contacts 106 of sheath assembly 110 may align with leads 60, such that each of contacts 106 may receive a corresponding lead 60.

Referring collectively to Figs. 1-4, coil housing 20, insulators 30, flange 50, adaptor sleeve 102, and feed-through base 104 may be aligned along a common central axis. Adaptor sleeve 102 may generally be cylindrical in shape. Sheath assembly 110 may be open at one end of adaptor sleeve 102, where flange 116 extends orthogonally outward from adaptor sleeve 102. Feed-through base 104 may be attached at the other end of adaptor sleeve 102 to enclose one end of sheath assembly 110.

Sheath assembly 110 is configured to cover a lower portion of switch body 10. More particularly, adaptor sleeve 102 may encircle coil housing 20 and leads 60 of switch body 10. In one implementation, adaptor sleeve 102 may be slid over an end of coil housing 20 to bring flange 116 into contact with flange 50. Thus, sheath assembly 110 may be attached to flange 50 at flange 116. In one aspect, flange 116 may be brazed to flange 50. In another aspect flange 116 may be welded to flange 50.

Fig. 5 is a schematic partial cross-sectional diagram illustrating of relay assembly 100 showing an envelope 118. Sheath assembly 110 may form envelope 118 around coil housing 20, leads 60, contacts 106, and the portions of conductors 108 that do not extend through feed-through base 104. Envelope 118 may provide an area to encapsulate a portion of relay switch 10, leads 60, contacts 106, and the portions of conductors 108 that do not extend through feed-through base 104. Envelope 18 may provides an area to encapsulate a portion of relay switch 10, leads 60, contacts 106, and/or conductors 108 in an epoxy resin within envelope 118. Envelope 118 may be open to air through apertures 114 (Fig. 2B). In configurations described herein, apertures 114 in adaptor sleeve 102 may be used to inject resin 120 into envelope 118. In one implementation, resin 120 (shown with a shaded pattern in Fig. 5) may include a thermoplastic polytherimide resin that, when injected and cured within envelope 118, can withstand high temperatures (e.g., of at least 200 degrees C) and high pressures (e.g., of at least 170,000 kPa (25,000 psi)).

Fig. 6 is a schematic cross-sectional diagram illustrating a magnetic actuating component 22 of relay assembly 100. Magnetic actuating component 22 may be included in switch body 10 within coil housing 20. As shown in Fig. 6, magnetic actuating component 22 may include an inner coil 24, and an outer coil 26 in an encapsulant 28. Magnetic actuating component 22 may move internal switching components to selectively engage electrical contacts 40 (e.g., Fig. 4) and/or leads 60. Inner coil 24 and outer coil 26 may include high-temperature-resistant wires with a maximum operating temperature of at least 200 degrees C. In an exemplary implementation, coils 24 and 26 may both have a nominal voltage or 26.5 V.D.C. and a resistance of about 80 Ohms. Inner coil 24 may include an American Wire Gauge (AWG) wire size of 39 with 1400 turns, while outer coil 26 may include an AWG wire size of 41.5 with 525 turns. Encapsulant 28 may include a thermoset material, such as FIBERITE EPON Resin 9405, or a similar thermoset material. Encapsulant 28 may be cured and the assemble magnetic actuating component 22 may be inserted into coil housing 20 before adaptor sleeve 102 is slid over coil housing 20. It should be understood that coils 24 and 26 having other characteristics may be used based on the implementation.

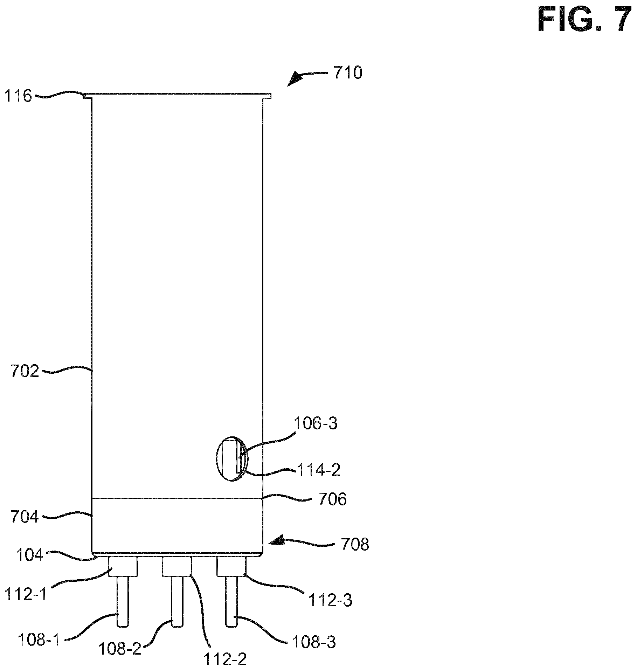

Fig. 7 is schematic side view of a reinforcing sheath assembly 710 for relay assembly 100, according to another implementation described herein. Reinforcing sheath assembly 710 includes an upper adaptor sleeve 702, a lower adaptor sleeve 704, feed-through base 104, multiple contacts 106, multiple conductors 108, multiple insulators 112, multiple apertures 114, and flange 116. Reinforcing sheath assembly 710 may be configured similar to reinforcing sheath assembly 110 described above, with the exception that upper adaptor sleeve 702 and lower adaptor sleeve 704 may be assembled separately and joined by a weld 706. Upper adaptor sleeve 702 may include apertures 114 and flange 116 in a configuration similar to that of adaptor sleeve 102 described above. Lower adaptor sleeve 704 may be joined to feed-through base 104 with contacts 106, conductors 108, and insulators 112 configured as described above in connection with, for example, Figs. 2A-2B.

Thus, in the configuration of Fig. 7, lower adaptor sleeve 704 and feed-through base 104 may be assembled as a cup 708 including contacts 106, conductors 108, and insulators 112. Upper adaptor sleeve 702 may be attached at flange 116 to switch body 10 at flange 50 (e.g., similar to as shown in Fig. 1); contacts 108 may be aligned with and receive leads 60 from switch body 10; then cup 708 may be attached to the open end (e.g., the end opposite flange 116) of upper adaptor sleeve 702 as a separate weld process.

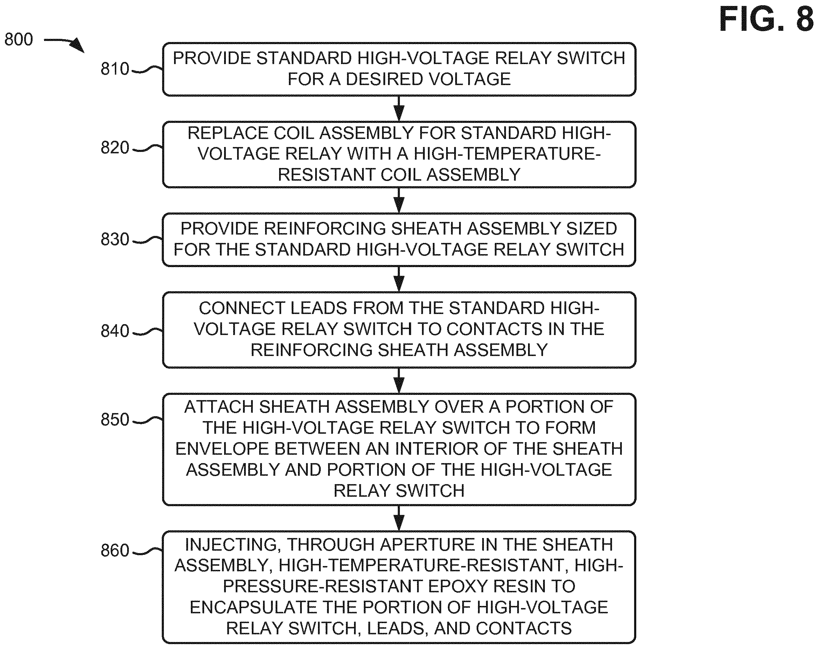

Fig. 8 is a flow diagram of an exemplary process 800 for converting a standard high voltage vacuum relay into a high-temperature, high-pressure vacuum relay according to an implementation described herein. As shown in Fig. 8, process 800 may include providing a standard high-voltage relay switch for a desired voltage (block 810) and replacing a coil assembly for the standard high-voltage relay with a high-temperature-resistant coil assembly (block 820). For example, a high-voltage relay sized for a particular application, such as relay switch 10, may be selected. The standard coil assembly for the high-voltage relay may be replaced with magnetic actuating component 22 including inner coil 24 and outer coil 26 of high-temperature-resistant wires with a maximum operating temperature of at least 200 degrees C.

Process 800 may also include providing a reinforcing sheath assembly sized for the standard high-voltage relay switch (block 830), connecting leads from the standard high-voltage relay switch to contacts in the reinforcing sheath assembly (block 840), and attaching a sheath assembly over a portion of the high-voltage relay switch to form an envelope between an interior of the sheath assembly and the portion of the high-voltage relay switch (block 850). For example, sheath assembly 110 or sheath assembly 710 may be selected for the required physical dimensions (e.g., axial length, cylinder diameter, number/size of leads, etc.) of relay switch 10. Sheath assembly 110/710 may include a cylindrical adaptor sleeve (e.g., adaptor sleeve 102/upper adaptor sleeve 702) with apertures 114 in the wall of the adaptor sleeve. The cylindrical adaptor sleeve may also include feed-through base 104 that includes a set of conductors 108 with contacts 106. Sheath assembly 110/710 may be slid over an end of relay switch 10 to connect contacts 106 with leads 60. As shown, for example, in Fig. 5, an upper portion of sheath assembly may be connected (e.g., welded/brazed) at an interface of flanges 50 and 116. In another implementation, flanges 50 and 116 may be joined before contacts 106 are connected to leads 60 and feed-through base 104/cup 708 is joined to adaptor sleeve 102/upper adaptor sleeve 702. When sheath assembly 110/710 is secured to relay switch 10 an air envelope 118 is formed that is accessible through apertures 114.

Process 800 may further include injecting, through one of the apertures in the sheath assembly, high-temperature-resistant, high-pressure-resistant epoxy resin to encapsulate the portion of the high-voltage relay switch, the leads, and the contacts (block 860). For example, a thermoplastic polytherimide resin 120 may be injected through one of apertures 114. Air may exit through another of apertures 114 to permit a void-free encapsulation. When the thermoplastic polytherimide resin 120 is injected and cured within envelope 118, relay assembly 100 can operate at high temperatures (e.g., of at least 200 degrees C) and high pressures (e.g., of at least 170,000 kPa (25,000 psi)).

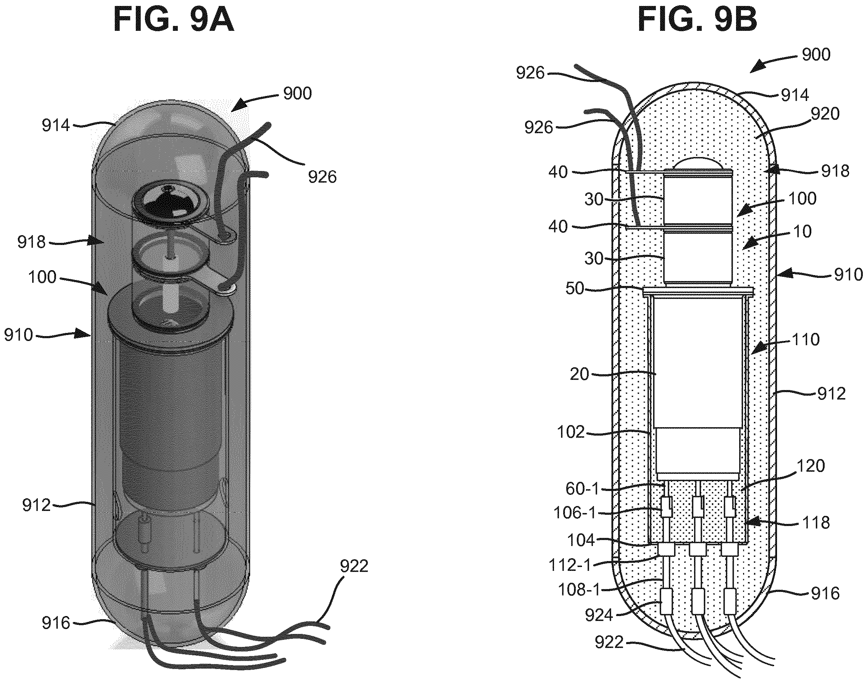

Figs. 9A and 9B are a schematic side perspective view and a schematic partial cross-sectional diagram of a high-temperature, high-pressure vacuum relay assembly 900 according to another implementation described herein. Referring collectively to Figs. 9A and 9B, in one implementation, relay assembly 900 may include all the components of relay assembly 100 within an enclosure 910. Enclosure 910 may include, for example, a cylindrical tube 912 enclosed at both ends with endcaps 914 and 916. Other shapes for enclosure 910 may be used.

Enclosure 910 may be made from a heat-resistant plastic material, such as a thermoplastic material that is resistant to deformation at temperatures of up to 200 degrees Celsius (C). In one implementation, enclosure 910 may be molded from the same material as (or a similar material to) that of thermoplastic polytherimide resin 120. Tube 912, endcap 914, and endcap 916 may be made from the same material or different materials. In one implementation, endcaps 914 and 916 may be secured to tube 912, such as via a threaded connection, bonding, welding, etc.

Enclosure 910 may form an envelope 918 around relay assembly 100. According to an implementation, envelope 918 may be filled with epoxy resin(s) cured to form a thermoset polymer 920. Particularly, thermoset polymer 920 may surround conductors 108, insulators 112, and contacts 40 inside envelope 918. In some implementations, one or more of tube 912, endcap 914, or endcap 916 may include a port to receive the epoxy resin. In other implementations, one or more of endcap 914 or endcap 916 may be secured to tube 912 after the addition of the epoxy resin for thermoset polymer 920.

As shown in Fig. 9B, coil wires 922 may protrude through enclosure 910 (e.g., endcap 916) and attach to conductors 108 at connectors 924. Thus, connectors 924 and a portion of coil wires 922 may also be encapsulated in thermoset polymer 920 inside envelope 918. Similarly, wires 926 may be connected to contacts 40 so that a portion of wires 926 and contacts 40 may be encapsulated in thermoset polymer 920 inside envelope 918. In one implementation, pass-through holes (not labeled) may be drilled through a portion of enclosure 910 for wires 922/926 to pass through. Coil wires 922 may be connected to conductors 108 and wires 926 may be connected to contacts 40 prior to insertion of the epoxy resin for thermoset polymer 920 into envelope 118.

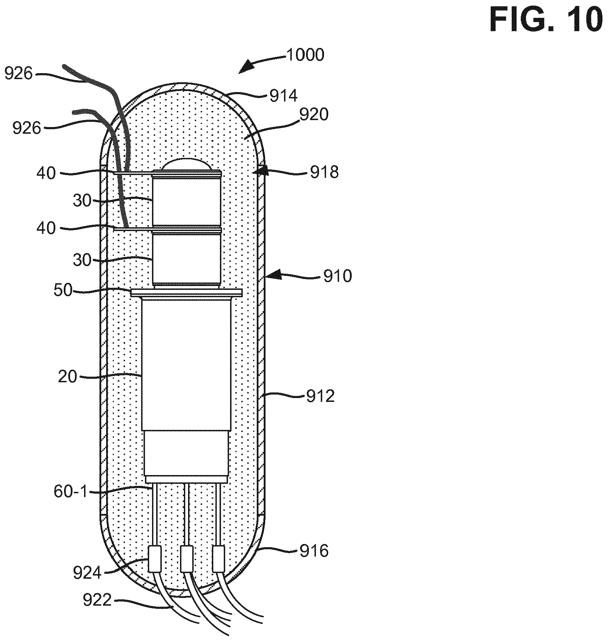

In one implementation, enclosure 910 may be applied to relay assembly 100 after completion, for example, of the steps of process 800. In another implementation, as shown in Fig. 10, enclosure 910 and thermoset polymer 920 may be applied over switch body 10 without the use of reinforcing sheath assembly 110. In this implementation, leads 60 may be connected directly to coil wires 922 (e.g., via connectors 924), such that adaptor sleeve 102, feed-through base 104, contacts 106, conductors 108, insulators 112, and resin 120 may be eliminated from the configuration shown in Figs. 9A and 9B.

The foregoing description of exemplary implementations provides illustration and description, but is not intended to be exhaustive or to limit the embodiments described herein to the precise form disclosed. Modifications and variations are possible in light of the above teachings or may be acquired from practice of the embodiments. For example, implementations described herein have been described with respect to high-temperature, high-pressure environments. In other cases, implementations may also be used in conjunction with other devices and environments, such as medium or low voltage equipment and/or medium/low-temperature environments or medium/low-pressure environments.

Implementations have been described herein primarily in the context of converting a standard relay switch to one suited for high-temperature, high-pressure environments. In other implementations, a similar relay switch for high-temperature, high-pressure environments may be manufactured as an originally manufactured component.

Various changes of form, design, or arrangement may be made to the invention without departing from the scope of the invention. Therefore, the above-mentioned description is to be considered exemplary, rather than limiting, and the true scope of the invention is that defined in the following claims.

No element, act, or instruction used in the description of the present application should be construed as critical or essential to the invention unless explicitly described as such. Also, as used herein, the article "a" is intended to include one or more items. Further, the phrase "based on" is intended to mean "based, at least in part, on" unless explicitly stated otherwise.

## Claims

1. A reinforcing sheath (110, 710) for a high-voltage relay switch, comprising:
a substantially cylindrical adaptor sleeve (102, 702) with one or more openings in a wall of the adaptor sleeve (102, 702), wherein a first end of the adaptor sleeve (102, 702) has a diameter sized to encircle at least a portion of the high-voltage relay switch and configured to attach to a flange (50) of the high-voltage relay switch; and
a feed-through base (104, 708), attached to a second end of the adaptor sleeve (102, 702) to enclose the second end of the adaptor sleeve (102, 702), wherein the feed-through base (104, 708) includes:
multiple holes through which conductors (108) extend from inside the adaptor sleeve (102, 702) to outside the adaptor sleeve (102, 702),
multiple contacts (106), inside the adaptor sleeve (102, 702), configured to join each conductor (108) to one of multiple leads (60) extending from the high-voltage relay switch, and
multiple insulators (112), adjacent to each of the multiple holes, through which each conductor (108) extends,
wherein the reinforcing sheath (110, 710), when attached to the flange (50), is configured to form an envelope (118) around: a portion of the high-voltage relay switch comprising a substantially cylindrical housing (20) that houses a coil; the multiple contacts (106); and the multiple leads (60), and
wherein the envelope (118) provides an area to encapsulate: the portion of the high-voltage relay switch; the multiple contacts (106); and the multiple leads (60) in a resin within the envelope (118).

2. A relay assembly (100), comprising the reinforcing sheath of claim 1 and a high-voltage relay switch, wherein the high-voltage relay switch comprises:
a switch body (10) including a substantially cylindrical housing (20) that houses a coil and other internal switching components, wherein the switch body (10) includes:
a flange (50) extending orthogonally from the substantially cylindrical housing (20), and
multiple leads (60) extending from an end of the cylindrical housing (20);
wherein the flange (50), the adaptor sleeve (102, 702), and the feed-through base (104, 708) form the envelope (118) around: the portion of the substantially cylindrical housing (20) that houses the coil; the multiple contacts (106); and the multiple leads (60); and
a resin encapsulating: the portion of the substantially cylindrical housing (20) that houses the coil; the multiple contacts (106); and the multiple leads (60) within the envelope (118).

3. The relay assembly of claim 1 or claim 2, wherein the resin includes a thermoplastic polytherimide resin.

4. The relay assembly of claim 2 or 3, wherein the relay assembly is configured to remain operational at an atmospheric pressure of at least 170,000 kPa (25,000 pounds per square inch (PSI)).

5. The relay assembly of any one of claims 2 to 4, wherein the relay assembly remains operational at a temperature of up to 200°C.

6. The relay assembly of any one of claims 2 to 5, wherein the resin further encapsulates a portion of each conductor (108).

7. The relay assembly of any one of claims 2 to 6, wherein the resin encapsulating the portion of the substantially cylindrical housing (20), the multiple contacts (106), and the multiple leads (60) is free of voids within the envelope (118).

8. The relay assembly of any one of claims 2 to 7, wherein the adaptor sleeve (102, 702) consists of a stainless steel.

9. The relay assembly of any one of claims 2 to 8, wherein the feed-through base (104, 708) includes a stainless steel disc joined to the second end of the adaptor sleeve (102, 702).

10. The relay assembly of claim 9, wherein the multiple insulators (112) include a ceramic material brazed to the stainless steel disc.

11. The relay assembly of any one of claims 2 to 10, wherein each of the multiple contacts (106) are configured to have a wiping fit on one of the multiple leads (60).

12. The relay assembly of any one of claims 2 to 11, further comprising:
an enclosure (910) that surrounds the switch body, the adaptor sleeve (102, 702), and the feed-through base (104, 708), wherein the enclosure forms an envelope (118) around the feed-through base (104, 708); and
a thermoset polymer that encapsulates the switch body, the adaptor sleeve (102, 702), and the feed-through base (104, 708).

13. A method, comprising:
providing a standard high-voltage relay switch for a desired voltage rating;
replacing a coil assembly of the standard high-voltage relay switch with a high-temperature-resistant coil assembly;
providing the reinforcing sheath (110, 710) of claim 1 sized for the standard high-voltage relay switch;
connecting leads (60) from the standard high-voltage relay switch to contacts (106) in the reinforcing sheath;
attaching the reinforcing sheath (110, 710) over a portion of the standard high-voltage relay switch to form an envelope (118) between an interior of the reinforcing sheath (110, 710) and the high-temperature-resistant coil assembly; and
injecting, through an aperture in the reinforcing sheath (110, 710), a high-temperature-resistant, high-pressure-resistant epoxy resin to encapsulate the high-temperature-resistant coil assembly, the leads (60), and the contacts (106).

14. The method of claim 13, further comprising:
providing an enclosure (910) that surrounds the standard high-voltage relay switch and the reinforcing sheath (110, 710), wherein the enclosure (910) forms another envelope (918) around the standard high-voltage relay switch and the reinforcing sheath (110, 710);
connecting, to the contacts in the reinforcing sheath (110, 710), wires that protrude through the enclosure (910); and
injecting, through an opening in the enclosure (910) and into the other envelope (918), resin for a thermoset polymer that encapsulates the standard high-voltage relay switch and the reinforcing sheath (110, 710).

## Patentansprüche

1. Verstärkungshülle (110, 710) für einen Hochspannungs-Relaisschalter, umfassend:
eine im Wesentlichen zylindrische Adaptermuffe (102, 702) mit einer oder mehreren Öffnungen in einer Wand der Adaptermuffe (102, 702), wobei ein erstes Ende der Adaptermuffe (102, 702) einen Durchmesser besitzt, der so bemessen ist, dass er mindestens einen Abschnitt des Hochspannungs-Relaisschalters einschließt, und ausgebildet ist zum Anbringen an einen Flansch (50) des Hochspannungs-Relaisschalters; und
eine Durchgangsbasis (104, 708), an einem zweiten Ende der Adaptermuffe (102, 702) angebracht, um das zweite Ende der Adaptermuffe (102, 702) zu umschließen, wobei die Durchgangsbasis (104, 708) enthält:
mehrere Löcher, durch die sich Leiter (108) von innerhalb der Adaptermuffe (102, 702) zu außerhalb der Adaptermuffe (102, 702) erstrecken,
mehrere Kontakte (106) innerhalb der Adaptermuffe (102, 702), ausgebildet zum Verbinden jedes Leiters (108) mit einer von mehreren Leitungen (60), die sich von dem Hochspannungs-Relaisschalter aus erstrecken, und
mehrere Isolatoren (112), bei jedem der mehreren Löcher, durch die sich jeder Leiter (108) erstreckt,
wobei die Verstärkungshülle (110, 710) beim Anbringen an den Flansch (50) ausgebildet ist zum Ausbilden einer Umhüllung (118) um: einen Abschnitt des Hochspannungs-Relaisschalters, umfassend ein im Wesentlichen zylindrisches Gehäuse (20), das eine Spule aufnimmt; die mehreren Kontakte (106) und die mehreren Leitungen (60), und
wobei die Umhüllung (118) einen Bereich bereitstellt zum Kapseln: des Abschnitts des Hochspannungs-Relaisschalters; der mehreren Kontakte (106) und der mehreren Leitungen (60) in einem Harz innerhalb der Umhüllung (118).

2. Relaisbaugruppe (100), umfassend die Verstärkungshülle nach Anspruch 1 und einen Hochspannungs-Relaisschalter, wobei der Hochspannungs-Relaisschalter umfasst:
einen Schalterkörper (10) mit einem im Wesentlichen zylindrischen Gehäuse (20), das eine Spule und andere interne Schaltkomponenten aufnimmt, wobei der Schalterkörper (10) enthält:
einen Flansch (50), der sich orthogonal von dem im Wesentlichen zylindrischen Gehäuse (20) erstreckt, und
mehrere Leitungen (60), die sich von einem Ende des zylindrischen Gehäuses (20) erstrecken;
wobei der Flansch (50), die Adaptermuffe (102, 702) und die Durchgangsbasis (104, 708) die Umhüllung (118) bilden um: den Abschnitt des im Wesentlichen zylindrischen Gehäuses (20), der die Spule aufnimmt; die mehreren Kontakte (106) und die mehreren Leitungen (60); und
ein Harz, das kapselt: den Abschnitt des im Wesentlichen zylindrischen Gehäuses (20), der die Spule aufnimmt; die mehreren Kontakte (106) und die mehreren Leitungen (60) innerhalb der Umhüllung (118).

3. Relaisbaugruppe nach Anspruch 1 oder Anspruch 2, wobei das Harz ein thermoplastisches Polyetherimidharz beinhaltet.

4. Relaisbaugruppe nach Anspruch 2 oder 3, wobei die Relaisbaugruppe dazu ausgebildet ist, bei einem atmosphärischen Druck von mindestens 170 000 kPa (25 000 Pounds per Square Inch (PSI)) betriebsfähig zu bleiben.

5. Relaisbaugruppe nach einem der Ansprüche 2 bis 4, wobei die Relaisbaugruppe bei einer Temperatur von bis zu 200°C betriebsfähig bleibt.

6. Relaisbaugruppe nach einem der Ansprüche 2 bis 5, wobei das Harz weiterhin einen Abschnitt jedes Leiters (108) kapselt.

7. Relaisbaugruppe nach einem der Ansprüche 2 bis 6, wobei das Harz, das den Abschnitt des im Wesentlichen zylindrischen Gehäuses (20), die mehreren Kontakte (106) und die mehreren Leitungen (60) kapselt, frei von Hohlräumen innerhalb der Umhüllung (118) ist.

8. Relaisbaugruppe nach einem der Ansprüche 2 bis 7, wobei die Adaptermuffe (102, 702) aus einem rostfreien Stahl besteht.

9. Relaisbaugruppe nach einem der Ansprüche 2 bis 8, wobei die Durchgangsbasis (104, 708) eine Scheibe aus rostfreiem Stahl enthält, die mit dem zweiten Ende der Adaptermuffe (102, 702) verbunden ist.

10. Relaisbaugruppe nach Anspruch 9, wobei die mehreren Isolatoren (112) ein an die Scheibe aus rostfreiem Stahl hartgelötetes Keramikmaterial enthalten.

11. Relaisbaugruppe nach einem der Ansprüche 2 bis 10, wobei jeder der mehreren Kontakte (106) so ausgebildet ist, dass er eine wippende Passung an einer der mehreren Leitungen (60) besitzt.

12. Relaisbaugruppe nach einem der Ansprüche 2 bis 11, weiterhin umfassend:
eine Verkleidung (910), die den Schalterkörper, die Adaptermuffe (102, 702) und die Durchgangsbasis (104, 708) umgibt, wobei die Verkleidung eine Umhüllung (118) um die Durchgangsbasis (104, 708) bildet; und
ein wärmehärtendes Polymer, das den Schalterkörper, die Adaptermuffe (102, 702) und die Durchgangsbasis (104, 708) kapselt.

13. Verfahren, umfassend:
Bereitstellen eines standardmäßigen Hochspannungs-Relaisschalters für eine gewünschte Nennspannung;
Ersetzen einer Spulenbaugruppe des standardmäßigen Hochspannungs-Relaisschalters mit einer hochtemperaturbeständigen Spulenbaugruppe;
Bereitstellen der Verstärkungshülle (110, 700) nach Anspruch 1, die für den standardmäßigen Hochspannungs-Relaisschalter bemessen ist;
Verbindungsleitungen (60) von dem standardmäßigen Hochspannungs-Relaisschalter zu Kontakten (106) in der Verstärkungshülle;
Anbringen der Verstärkungshülle (110, 710) über einem Abschnitt des standardmäßigen Hochspannungs-Relaisschalters, um eine Umhüllung (118) zwischen einem Inneren der Verstärkungshülle (110, 710) und der hochtemperaturbeständigen Spulenbaugruppe auszubilden; und
Einspritzen, durch eine Öffnung in der Verstärkungshülle (110, 710), eines hochtemperaturbeständigen hochdruckbeständigen Epoxidharzes zum Kapseln der hochtemperaturbeständigen Spulenbaugruppe, der Leitungen (60) und der Kontakte (106).

14. Verfahren nach Anspruch 13, weiterhin umfassend:
Bereitstellen einer Verkleidung (910), die den standardmäßigen Hochspannungs-Relaisschalter und die Verstärkungshülle (110, 710) umgibt, wobei die Verkleidung (910) eine andere Umhüllung (918) um den standardmäßigen Hochspannungs-Relaisschalter und die Verstärkungshülle (110, 710) bildet;
Anschließen, mit den Kontakten in der Verstärkungshülle (110, 710), von Drähten, die durch die Verkleidung (910) vorstehen; und
Einspritzen, durch eine Öffnung in der Verkleidung (910) und in die äußere Umhüllung (918), von Harz für ein wärmehärtendes Polymer, das den standardmäßigen Hochspannungs-Relaisschalter und die Verstärkungshülle (110, 710) kapselt.

## Revendications

1. Gaine de renforcement (110, 710) pour un commutateur à relais à haute tension, comprenant :
un manchon adaptateur sensiblement cylindrique (102, 702) avec une ou plusieurs ouvertures dans une paroi du manchon adaptateur (102, 702), dans laquelle une première extrémité du manchon adaptateur (102, 702) a un diamètre dimensionné pour entourer au moins une partie du commutateur à relais à haute tension et est configurée pour se fixer à une bride (50) du commutateur à relais à haute tension ; et
une base de traversée (104, 708), fixée à une seconde extrémité du manchon adaptateur (102, 702) pour entourer la seconde extrémité du manchon adaptateur (102, 702), dans laquelle la base de traversée (104, 708) comprend :
des trous multiples à travers lesquels des conducteurs (108) s'étendent de l'intérieur du manchon adaptateur (102, 702) vers l'extérieur du manchon adaptateur (102, 702),
des contacts multiples (106), à l'intérieur du manchon adaptateur (102, 702), configurés pour relier chaque conducteur (108) à l'un de fils multiples (60) s'étendant depuis le commutateur à relais à haute tension, et
des isolateurs multiples (112), adjacents à chacun des trous multiples, à travers lesquels s'étend chaque conducteur (108),
dans laquelle la gaine de renforcement (110, 710), lorsqu'elle est fixée à la bride (50), est configurée pour former une enveloppe (118) autour des éléments suivants : une section du commutateur à relais à haute tension comprenant un boîtier sensiblement cylindrique (20) qui contient une bobine ; les contacts multiples (106) ; et les fils multiples (60), et
dans laquelle l'enveloppe (118) forme une zone pour encapsuler les éléments suivants : la section du commutateur à relais à haute tension ; les contacts multiples (106) ; et les fils multiples (60) dans une résine au sein de l'enveloppe (118).

2. Ensemble à relais (100), comprenant la gaine de renforcement de la revendication 1 et un commutateur à relais à haute tension, dans lequel le commutateur à relais à haute tension comprend :
un corps de commutateur (10) comprenant un boîtier sensiblement cylindrique (20) qui contient une bobine et d'autres composants de commutation internes, dans lequel le corps de commutateur (10) comprend :
une bride (50) qui s'étend orthogonalement depuis le logement sensiblement cylindrique (20), et
des fils multiples (60) qui s'étendent depuis une extrémité du boîtier cylindrique (20) ;
dans lequel la bride (50), le manchon adaptateur (102, 702) et la base de traversée (104, 708) forment l'enveloppe (118) autour des éléments suivants : la section du logement sensiblement cylindrique (20) qui contient la bobine ; les contacts multiples (106) ; et les fils multiples (60) ; et
une résine encapsulant ; la section du logement sensiblement cylindrique (20) qui contient la bobine ; les contacts multiples (106) ; et les fils multiples (60) à l'intérieur de l'enveloppe (118).

3. Ensemble à relais selon la revendication 1 ou la revendication 2, dans lequel la résine comprend une résine thermoplastique polyétherimide.

4. Ensemble à relais selon la revendication 2 ou 3, dans lequel l'ensemble à relais est configuré pour rester opérationnel à une pression atmosphérique d'au moins 170 000 kPa (25 000 livres par pouce carré (PSI)).

5. Ensemble à relais selon l'une quelconque des revendications 2 à 4, dans lequel l'ensemble à relais reste opérationnel à une température pouvant atteindre 200 °C.

6. Ensemble à relais selon l'une quelconque des revendications 2 à 5, dans lequel la résine encapsule en outre une partie de chaque conducteur (108).

7. Ensemble à relais selon l'une quelconque des revendications 2 à 6, dans lequel la résine encapsulant la section du logement sensiblement cylindrique (20), les contacts multiples (106) et les fils multiples (60) est exempte de vides à l'intérieur de l'enveloppe (118) .

8. Ensemble à relais selon l'une quelconque des revendications 2 à 7, dans lequel le manchon adaptateur (102, 702) est constitué d'un acier inoxydable.

9. Ensemble à relais selon l'une quelconque des revendications 2 à 8, dans lequel la base de traversée (104, 708) comprend un disque en acier inoxydable relié à la seconde extrémité du manchon adaptateur (102, 702) .

10. Ensemble à relais selon la revendication 9, dans lequel les isolateurs multiples (112) comprennent un matériau céramique brasé au disque en acier inoxydable.

11. Ensemble à relais selon l'une quelconque des revendications 2 à 10, dans lequel chacun des contacts multiples (106) est configuré pour avoir un montage à balayage sur l'un des fils multiples (60).

12. Ensemble à relais selon l'une quelconque des revendications 2 à 11, comprenant en outre :
une enceinte (910) entourant le corps de commutateur, le manchon adaptateur (102, 702) et la base de traversée (104, 708), dans lequel l'enceinte forme une enveloppe (118) autour de la base de traversée (104, 708) ; et
un polymère thermodurcissable qui encapsule le corps de commutateur, le manchon adaptateur (102, 702) et la base de traversée (104, 708).

13. Procédé comprenant les étapes consistant à :
fournir un commutateur à relais standard à haute tension pour une tension nominale souhaitée ;
remplacer un ensemble de bobines du commutateur à relais standard à haute tension par un ensemble de bobines résistant aux températures élevées ;
fournir la gaine de renforcement (110, 710) de la revendication 1 dimensionnée pour le commutateur à relais standard à haute tension ;
connecter des fils (60) du commutateur à relais standard à haute tension aux contacts (106) dans la gaine de renforcement ;
fixer la gaine de renforcement (110, 710) sur une section du commutateur à relais standard à haute tension pour former une enveloppe (118) entre un intérieur de la gaine de renforcement (110, 710) et l'ensemble de bobines résistant aux températures élevées ; et
injecter, à travers une ouverture dans la gaine de renforcement (110, 710), une résine époxy résistante aux hautes températures et aux hautes pressions pour encapsuler l'ensemble de bobines résistant aux températures élevées, les fils (60) et les contacts (106) .

14. Procédé selon la revendication 13, comprenant en outre les étapes consistant à :
fournir une enceinte (910) qui entoure le commutateur à relais standard à haute tension et la gaine de renforcement (110, 710), dans lequel l'enceinte (910) forme une autre enveloppe (918) autour du commutateur à relais standard à haute tension et de la gaine de renforcement (110, 710) ;
connecter, aux contacts dans la gaine de renforcement (110, 710), des fils qui font saillie à travers l'enceinte (910) ; et
injecter, à travers une ouverture dans l'enceinte (910) et dans l'autre enveloppe (918), une résine pour un polymère thermodurcissable qui encapsule le commutateur à relais standard à haute tension et la gaine de renforcement (110, 710).
